Europäisches Patentamt

European Patent Office

Office européen des brevets

(19)

(11) **EP 0 690 585 B1**

(12) **FASCICULE DE BREVET EUROPEEN**

(45) Date de publication et mention
de la délivrance du brevet:
**16.08.2001 Bulletin 2001/33**

(51) Int Cl.$^7$: **H03M 13/00**

(21) Numéro de dépôt: **95410058.2**

(22) Date de dépôt: **21.06.1995**

(54) **Décodeur Reed-Solomon**

Reed-Solomon Dekoder

Reed-Solomon decoder

(84) Etats contractants désignés:
**DE FR GB IT**

(30) Priorité: **27.06.1994 FR 9408121**

(43) Date de publication de la demande:
**03.01.1996 Bulletin 1996/01**

(73) Titulaire: **STMicroelectronics S.A.**
**94250 Gentilly (FR)**

(72) Inventeur: **Meyer, Jacques**
**F-38700 Corenc (FR)**

(74) Mandataire: **de Beaumont, Michel**
**1bis, rue Champollion**
**38000 Grenoble (FR)**

(56) Documents cités:
**EP-A- 0 147 041        US-A- 5 170 399**

• **ELEKTRONIK, vol. 41, no. 22, Décembre 1992**
**MUNCHEN DE, pages 40-44, XP 000327407**
**MESTER 'Fehlerkorrektur in**
**Hochgeschwindigkeit'**

**Description**

La présente invention concerne un décodeur Reed-Solomon qui sert à corriger des erreurs subies par des données numériques lors d'une transmission (par voie électrique, hertzienne, ou autre), et plus particulièrement une partie de ce décodeur servant à fournir, dans un ordre adéquat, des données à corriger et les valeurs de correction respectives.

Un codage Reed-Solomon (RS) consiste à mettre sous forme de codes RS des paquets de données à transmettre, ces données pouvant ensuite être extraites des codes et corrigées au niveau d'un appareil récepteur. Un code RS est un ensemble de M données numériques que l'on associe à des coefficients d'un polynôme de degré M-1 qui est un multiple d'un polynôme générateur de degré 2t ayant 2t racines distinctes. Dans une transmission d'un tel code, on peut localiser et corriger jusqu'à t coefficients erronés.

Les coefficients d'un code RS sont en outre associés à des éléments d'un corps de Galois. Ainsi, si les coefficients à transmettre sont des nombres de n bits, on utilisera un corps de Galois de $2^n$ éléments, noté GF $(2^n)$. Dans ce corps de Galois, un code RS peut comporter jusqu'à $N=2^n-1$ coefficients.

Dans un corps de Galois, on définit l'addition et la multiplication de manière particulière. La multiplication est telle que les éléments successifs du corps peuvent être notés $0$, $\alpha^0$, $\alpha^1$, ... $\alpha^{N-1}$ et que $\alpha^i = \alpha^{i+N}$, où i est un entier positif ou négatif quelconque.

Pour transmettre un ensemble de M-2t données $a_{M-2t-1}$ ... $a_1$, $a_0$ selon un codage Reed-Solomon (M≤N) on forme le polynôme

$$a(x) = a_{M-2t-1} \cdot x^{M-2t-1} + ... + a_1 \cdot x + a_0.$$

Ensuite, on transmet les coefficients du polynôme

$$A(x) = x^{2t} \cdot a(x) + r(x),$$

où r(x) est le reste de la division du polynôme $x^{2t} \cdot a(x)$ par le polynôme générateur. Ainsi, les coefficients A du polynôme A(x) constituent un code RS, et ceux correspondant aux termes de degrés 2t à N-1 sont les coefficients a que l'on cherche à transmettre. Bien entendu, la transmission est susceptible d'erreurs et certains des coefficients A reçus peuvent être erronés.

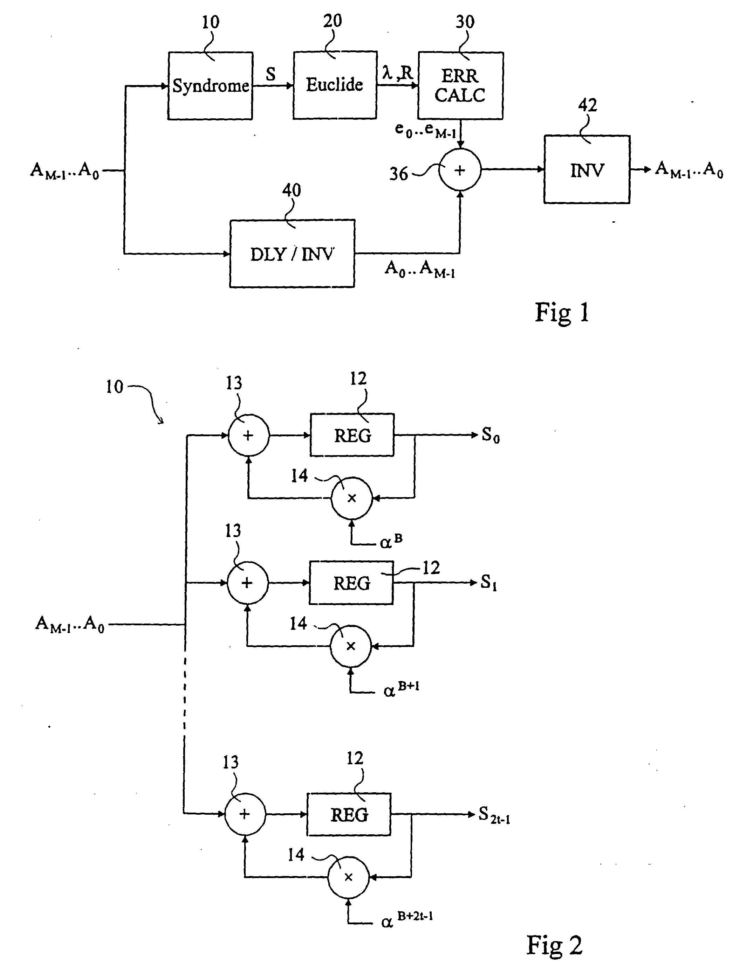

La figure 1 représente une architecture classique de décodeur Reed-Solomon, prévu pour corriger jusqu'à t coefficients erronés parmi les coefficients A. Les coefficients A sont fournis au décodeur dans l'ordre correspondant aux termes de degrés décroissants du polynôme A(x).

Un circuit 10 fournit les coefficients d'un polynôme syndrome S(x) (ci-après appelé syndrome) de degré 2t-1. Le coefficient du terme de degré i (i=0, 1,... 2t-1) de ce syndrome, s'exprime par :

$$S_i = A(\alpha^{B+i}),$$

où $\alpha^{B+0}$, $\alpha^{B+1}$... $\alpha^{B+2t-1}$ sont les racines du polynôme générateur et B une constante.

La figure 2 représente une structure classique du circuit 10 permettant de fournir les coefficients du syndrome. Cette structure comprend 2t compteurs polynômiaux associés respectivement aux coefficients $S_0$ à $S_{2t-1}$ du syndrome. Chaque compteur polynômial associé à un coefficient $S_i$ du syndrome comprend un registre 12 précédé d'un additionneur 13. Une première entrée de l'additionneur 13 reçoit successivement les coefficients $A_{M-1}$ à $A_0$. La deuxième entrée de l'additionneur 13 reçoit la sortie du registre 12 multipliée par $\alpha^{B+i}$ par un multiplieur 14.

A chaque arrivée d'un coefficient $A_j$, le contenu du registre 12 est remplacé par son contenu initial augmenté de $A_j \cdot \alpha^{B+i}$. A l'arrivée du coefficient $A_{M-1}$, le registre 12 contient la valeur du polynôme A(x) pour $x=\alpha^{B+i}$, c'est-à-dire le coefficient $S_i$ du syndrome. Les coefficients A doivent être fournis aux compteurs polynômiaux dans l'ordre correspondant aux termes de degrés décroissants du polynôme A(x).

Un circuit 20 de la figure 1 fournit, à partir des coefficients du syndrome, les coefficients d'un polynôme λ(x), dit polynôme de localisation d'erreur, de degré inférieur ou égal à t, et d'un polynôme R(x), dit polynôme de correction d'erreur, de degré inférieur à t, tels que

$$x^{2t} \cdot \gamma(x) + \lambda(x) \cdot S(x) = R(x)$$

où γ(x) est un polynôme que l'on ne cherche pas à déterminer.

Le polynôme λ(x) a au plus t racines distinctes. Si $\alpha^r$ (r=0, 1,... M-1) est une racine du polynôme λ(x), le coefficient $A_{N-r}$ a été transmis avec une erreur. L'erreur sur ce coefficient s'exprime par

$$e_r = R(\alpha^r)/\alpha^r \cdot \lambda'(\alpha^r) \qquad (1)$$

où λ' est le polynôme dérivé du polynôme λ.

Pour trouver les coefficients des polynômes λ (x) et R(x) le circuit 20 met en oeuvre l'algorithme d'Euclide.

L'article de IEEE Transactions on Computers, Vol. C-34, N° 5, Mai 1985, "A VLSI Design of a Pipeline Reed-Solomon Decoder" décrit un exemple d'application d'algorithme d'Euclide et un circuit pour mettre en oeuvre l'algorithme d'Euclide dans cet exemple.

Un circuit 30 à la figure 1 sert, à partir des coefficients des polynômes λ(x) et R(x), à trouver les racines du polynôme λ(x) et à calculer les erreurs selon la relation (1).

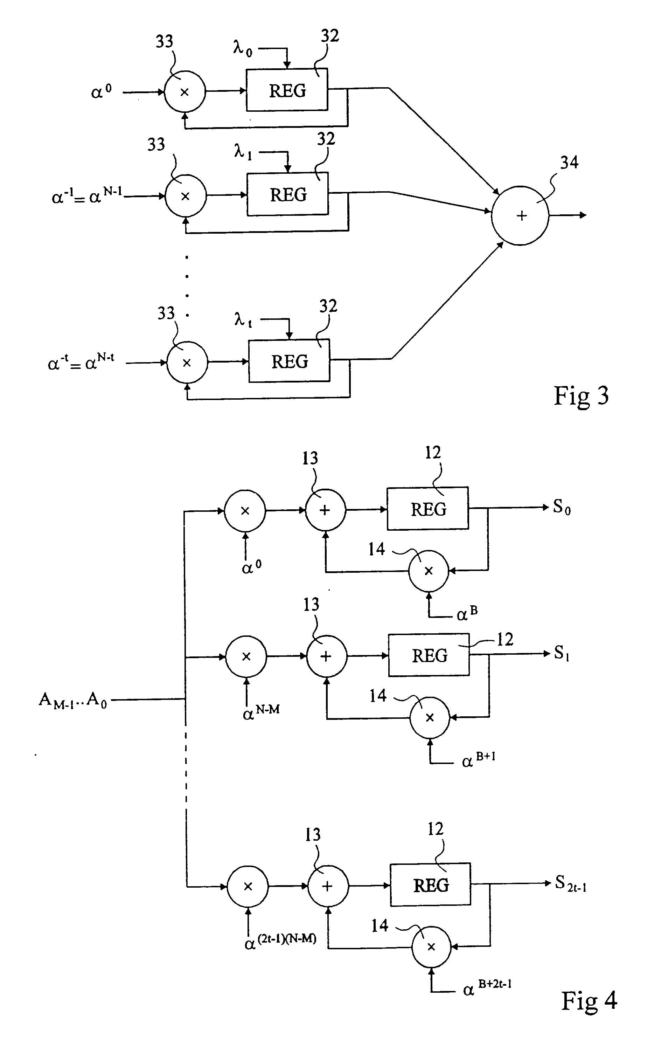

La figure 3 représente une structure classique de la partie du circuit 30 permettant de trouver les racines du polynôme $\lambda(x)$. Cette structure calcule successivement les valeurs du polynôme $\lambda(x)$ pour x valant successivement $\alpha^0$, $\alpha^{-1}$... $\alpha^{1-M}$. Plutôt que de prévoir M compteurs polynômiaux pour calculer la valeur du polynôme $\lambda(x)$ pour chacune des valeurs $\alpha^0$ à $\alpha^{1-M}$, ce qui occuperait une surface notable, on prévoit t+1 cellules de calcul associés respectivement aux coefficients $\lambda_0$ à $\lambda_t$ du polynôme $\lambda(x)$.

Chaque cellule associée à un coefficient $\lambda_i$ comprend un registre 32 précédé d'un multiplieur 33 dont une première entrée reçoit la sortie du registre 32 et une deuxième la valeur $\alpha^{-i}=\alpha^{N-i}$.

Les sorties des registres 32 sont fournies à des entrées respectives d'un additionneur 34.

Initialement, les coefficients $\lambda_0$ à $\lambda_t$ sont écrits dans les registres 32 respectifs. L'additionneur 34 fournit alors la valeur du polynôme $\lambda(x)$ pour $x=\alpha^0=1$.

Ensuite, les registres 32 sont validés en écriture à chacune de M-1 étapes successives. Ainsi, à la (j-i)ème étape, le registre 32 associé au coefficient $\lambda_i$ contient la valeur $\lambda_i \cdot \alpha^{-ij}$. L'additionneur 34 fournit alors la valeur du polynôme $\lambda(x)$ pour $x=\alpha^{-j}$.

Ainsi, la structure de la figure 3 fournit, en M étapes successives, les valeurs du polynôme $\lambda(x)$ pour x valant successivement $\alpha^0$ à $\alpha^{1-M}$. A chacune de ces étapes, l'erreur e correspondante est calculée. Si à une étape r, l'additionneur 34 fournit une valeur non nulle, l'erreur er est nulle. Dans le cas contraire, l'erreur $e_r$ est calculée selon la relation (1). Il en résulte que les erreurs e sont calculées dans l'ordre correspondant aux coefficients des termes de degrés croissants du polynôme A (x).

Comme le représente la figure 1, les erreurs $e_0$ à $e_{M-1}$ sont successivement fournies à une première entrée d'un additionneur 36. En même temps, l'additionneur reçoit sur une deuxième entrée les coefficients A correspondants, c'est-à-dire successivement $A_0$ à $A_{M-1}$. Les coefficients A sont fournis à l'additionneur 36 par un circuit 40 de retard et d'inversion d'ordre. Le retard introduit est destiné à compenser M cycles de calcul des coefficients du polynôme syndrome par le circuit 10 et 2t cycles nécessaires à fournir les coefficients des polynômes $\lambda(x)$ et R(x) par le circuit 20. L'ordre de transmission des coefficients A corrigés fournis par l'additionneur 36 est de nouveau inversé par un circuit d'inversion 42 pour rétablir l'ordre de transmission initial. Ceci est nécessaire pour éviter un temps de latence qui s'écoulerait lors de la fourniture des 2t coefficients de degré le plus bas du polynôme A, qui ne correspondent pas à des coefficients a souhaités.

Ainsi, un décodeur Reed-Solomon classique nécessite deux circuits d'inversion dont chacun contient au moins M bascules gérées par un circuit de commande complexe.

Un objet de la présente invention est de prévoir un décodeur Reed-Solomon permettant de fournir les erreurs des coefficients à traiter dans l'ordre de transmission initial de ces coefficients.

Pour atteindre cet objet, l'invention est basée sur l'inversion de l'ordre d'essai des racines du polynôme $\lambda(x)$, c'est-à-dire que, au lieu d'essayer les valeurs $\alpha^1$ à $\alpha^{1-M}$, on essaie les valeurs $\alpha^1$ à $\alpha^M$, ce que permet aussi la structure d'essais successifs de la figure 3. Toutefois, en procédant directement ainsi, les indices des coefficients à corriger correspondants seraient N-1 à N-M qui ne correspondent effectivement aux coefficients $A_{M-1}$ à $A_0$ que dans le cas particulier où M=N.

Pour que l'inversion des essais soit applicable dans le cas général, la présente invention prévoit en outre de considérer les M coefficients $A_{M-1}$ à $A_0$ comme les coefficients des termes de plus haut degré d'un polynôme de degré N-1 dont les N-M termes de plus bas degré sont nuls. Pour cela, il suffit, dans le circuit de calcul des coefficients du syndrome, d'utiliser le polynôme $x^{N-M} \cdot A(x)$ au lieu du polynôme A(x).

La présente invention prévoit plus particulièrement un décodeur Reed-Solomon recevant des suites de M données de n bits correspondant à des coefficients de polynômes de degré M-1 multiples d'un polynôme générateur de racines successives $\alpha^B$ à $\alpha^{B+2t-1}$, où B est une constante, les coefficients étant associés à des éléments d'un corps de Galois de $N+1=2^n$ éléments dont $\alpha$ est un élément non nul et non-unitaire. Le décodeur comprend 2t compteurs polynômiaux recevant successivement les M données de chaque suite et dont celui de rang i, i=0,1... 2t-1, fournit le coefficient du terme de degré i d'un polynôme syndrome, égal à la valeur dudit polynôme de degré M-1 pour la racine $\alpha^{B+i}$. Un circuit fournit les coefficients d'un polynôme de localisation d'erreur de degré au plus égal à t à partir des coefficients du polynôme syndrome. Un autre circuit trouve les racines du polynôme de localisation d'erreur par essais successifs de M valeurs du corps de Galois. Le compteur polynômial de rang i est précédé d'un multiplieur par $\alpha^{(B+i)(N-M)}$ et le circuit pour trouver les racines du polynôme de localisation d'erreur est prévu pour essayer successivement les valeurs $\alpha^1$ à $\alpha^M$.

Selon un mode de réalisation de la présente invention, si N=k(N-M), où k est un entier, le décodeur comprend k multiplieurs par respectivement $\alpha^{B(N-M)}$, $\alpha^{(B+1)(N-M)}$... $\alpha^{(B+k-1)(N-M)}$, dont celui de rang i, i=0,1,... k-1, précède les compteurs polynômiaux de rangs i+pk, où p varie entre 0 et la partie entière de (2t-i-1)/k.

Selon un mode de réalisation de la présente invention, le circuit pour trouver les racines du polynôme de localisation d'erreur comprend, pour chaque coefficient de terme de degré i du polynôme de localisation d'erreur, un registre stockant initialement ce coefficient et un multiplieur connecté pour successivement remplacer le contenu du registre par son contenu précédent multiplié par $\alpha^i$, la sortie de chaque multiplieur étant fournie à une entrée respective d'un additionneur.

Ces objets, caractéristiques et avantages ainsi que d'autres de la présente invention seront exposés plus en détail dans la description suivante de modes de réalisation particuliers faite à titre non-limitatif à l'aide des figures jointes parmi lesquelles :

la figure 1, précédemment décrite, représente schématiquement une architecture classique de décodeur Reed-Solomon ; la figure 2, précédemment décrite, représente une structure classique de circuit de calcul des coefficients d'un syndrome ;

la figure 3, précédemment décrite, représente une structure classique d'un circuit d'essais successifs de racines d'un polynôme de localisation d'erreur ;

la figure 4 représente un mode de réalisation de circuit de calcul selon l'invention des coefficients d'un syndrome ;

la figure 5 représente un mode de réalisation de circuit d'essais successifs de racines selon l'invention ; et

la figure 6 représente un mode de réalisation optimisé de circuit de calcul des coefficients d'un polynôme syndrome.

Pour pouvoir corriger M coefficients $A_{M-1}$ à $A_0$ d'un code Reed-Solomon sans modifier leur ordre d'arrivée, la présente invention propose de traiter les M coefficients comme s'ils correspondaient aux termes de plus haut degré d'un polynôme de degré N-1, les coefficients des N-M termes de plus bas degré étant considérés nuls (N étant le nombre d'éléments non nuls du corps de Galois utilisé et M le nombre de coefficients de chaque code Reed-Solomon). Ceci revient à multiplier le polynôme initial A(x) par $x^{N-M}$. Les coefficients du polynôme $x^{N-M} \cdot A(x)$ ainsi obtenu, constituent aussi un code Reed-Solomon puisque les racines du polynôme générateur du polynôme A(x) sont aussi des racines du polynôme $x^{N-M} \cdot A(x)$.

En procédant ainsi, le calcul des coefficients du syndrome est modifié puisque celui du terme de degré i s'exprime maintenant par

$$S_i = \alpha^{(B+i)(M-N)} \cdot A(\alpha^{B+i}).$$

La figure 4 représente un mode de réalisation de circuit de calcul des coefficients du syndrome selon l'invention. On retrouve des mêmes éléments qu'à la figure 2, désignés par des mêmes références. Le circuit diffère de celui de la figure 2 par le fait que chaque compteur polynômial associé à un coefficient $S_i$ est précédé d'un multiplieur 44 par $\alpha^{(B+i)(N-M)}$.

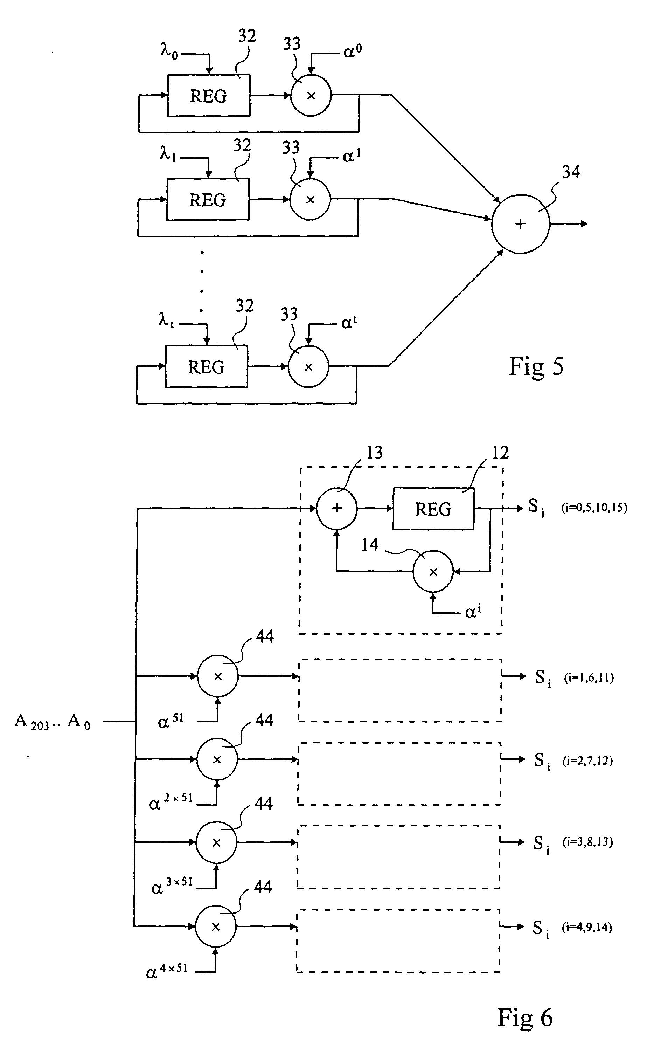

La figure 5 représente un mode de réalisation de circuit de détermination des racines du polynôme de localisation d'erreur $\lambda(x)$, par essais successifs des valeurs $\alpha^1$ à $\alpha^M$. Les M valeurs successives essayées dans cet ordre correspondent aux coefficients de termes de degrés N-1 à N-M d'un polynôme de degré N-1. Grâce à la multiplication du polynôme A(x) par $x^{N-M}$,

ces coefficients correspondent justement aux coefficients $A_{M-1}$ à $A_0$. Les valeurs étant essayées dans l'ordre correspondant à l'ordre d'arrivée des coefficients A, il est inutile de prévoir le circuit d'inversion 42 de la figure 1 et la gestion de l'inversion dans le circuit de retard 40, ce qui constitue une simplification notable du décodeur.

Dans ce circuit d'essais successifs, on retrouve des mêmes éléments qu'à la figure 3, désignés par des mêmes références. Toutefois, la structure diffère de celle de la figure 3 par le fait que l'additionneur 34 reçoit les sorties des multiplieurs 33 au lieu des sorties des registres 32 et que chaque multiplieur 33 associé à un coefficient $\lambda_i$ reçoit la valeur $\alpha^i$ au lieu de $\alpha^{-i}$.

Initialement, les coefficients $\lambda_0$ à $\lambda_t$ sont écrits dans les registres 32 respectifs. Alors, l'additionneur 34 fournit la valeur du polynôme $\lambda(x)$ pour $x=\alpha^1$. En M-1 étapes supplémentaires, les registres 32 sont validés en écriture et l'additionneur 34 fournit les valeurs du polynôme $\lambda(x)$ pour x variant de $\alpha^2$ à $\alpha^{M-1}$.

La figure 6 représente un mode de réalisation simplifié du circuit de calcul des coefficients du syndrome de la figure 4 dans un cas particulier où N est un multiple de N-M (N=k(N-M)). En effet, dans ce cas, chaque multiplieur 44 associé à un coefficient $S_i$ effectue la même multiplication que celui associé au coefficient $S_{i-k}$. Par conséquent, le multiplieur 44 associé au coefficient $S_i$ peut être supprimé et le compteur polynômial correspondant sera alimenté par le multiplieur 44 associé au coefficient $S_{i-k}$.

La figure 6 illustre la simplification qui en résulte à l'aide d'un exemple où N=255, M=204, B=0, et t=8, correspondant à la norme européenne de transmission par câble ou satellite de codes Reed-Solomon dans le cadre de la télévision numérique. Dans ce cas, N=5(N-M) et N-M=51. Les compteurs polynômiaux associés aux coefficients $S_0$, $S_5$, $S_{10}$ et $S_{15}$ sont directement alimentés par les coefficients $A_{203}$ à $A_0$. Les compteurs polynômiaux associés aux coefficients $S_1$, $S_6$ et $S_{11}$ sont précédés d'un multiplieur par $\alpha^{51}$. Les compteurs polynômiaux associés aux coefficients $S_2$, $S_7$ et $S_{12}$ sont précédés d'un multiplieur par $\alpha^{2 \cdot 51}$. Les compteurs polynômiaux associés aux coefficients $S_3$, $S_8$ et $S_{13}$ sont précédés d'un multiplieur par $\alpha^{3 \cdot 51}$. Finalement, les compteurs polynômiaux associés aux coefficients $S_4$, $S_9$ et $S_{14}$ sont précédés d'un multiplieur par $\alpha^{4 \cdot 51}$.

Dans cet exemple, on utilise que 4 multiplieurs aux entrées des compteurs polynômiaux à la place des 15 qu'il faudrait normalement.

## Revendications

1. Décodeur Reed-Solomon recevant des suites de M données de n bits correspondant à des coefficients de polynômes de degré M-1 multiples d'un polynôme générateur de racines successives $\alpha^B$ à $\alpha^{B+2t-1}$, où B est une constante, les coefficients étant associés à des éléments d'un corps de Galois de

N+1=$2^n$ éléments dont $\alpha$ est un élément non nul et non-unitaire, le décodeur comprenant :

- 2t compteurs polynômiaux (12-14) recevant successivement les M données de chaque suite et dont celui de rang i, i=0,1... 2t-1, fournit le coefficient ($S_i$) du terme de degré i d'un polynôme syndrome, égal à la valeur dudit polynôme de degré M-1 pour la racine $\alpha^{B+i}$ ;
- un circuit (20) fournissant les coefficients d'un polynôme de localisation d'erreur ($\lambda$) de degré au plus égal à t à partir des coefficients du polynôme syndrome ;
- un circuit (30) pour trouver les racines du polynôme de localisation d'erreur par essais successifs de M valeurs du corps de Galois ;

caractérisé en ce que :

- le compteur polynômial (12-14) de rang i est précédé d'un multiplieur (44) par $\alpha^{(B+i)(N-M)}$ et
- ledit circuit (30) pour trouver les racines du polynôme de localisation d'erreur est prévu pour essayer successivement les valeurs $\alpha^1$ à $\alpha^M$.

2. Décodeur Reed-Solomon selon la revendication 1, caractérisé en ce que, si N=k(N-M), où k est un entier, le décodeur comprend k multiplieurs (44) par respectivement $\alpha^{B(N-M)}$, $\alpha^{(B+1)(N-M)}$... $\alpha^{(B+k-1)(N-M)}$, dont celui de rang i, i=0,1,... k-1, précède les compteurs polynômiaux de rangs i+pk, où p varie entre 0 et la partie entière de (2t-i-1)/k.

3. Décodeur Reed-Solomon selon la revendication 1, caractérisé en ce que ledit circuit (30) pour trouver les racines du polynôme de localisation d'erreur ($\lambda$) comprend, pour chaque coefficient de terme de degré i du polynôme de localisation d'erreur, un registre (32) stockant initialement ce coefficient et un multiplieur (33) connecté pour successivement remplacer le contenu du registre par son contenu précédent multiplié par $\alpha^i$, la sortie de chaque multiplieur étant fournie à une entrée respective d'un additionneur (34).

4. Décodeur Reed-Solomon selon l'une quelconque des revendications précédentes, caractérisé en ce que N=255, M=204, B=0, et t=8.

**Patentansprüche**

1. Ein Reed-Solomon-Decoder zum Empfangen von Sequenzen von M n-Bit-Daten entsprechend Koeffizienten von Polynomen des Grades M-1, wobei diese Polynome Vielfache eines Generatorpolynoms sind mit aufeinanderfolgenden Wurzeln $\alpha^B$ bis $\alpha^{B+2t-1}$, wobei B eine Konstante ist und wobei die Koeffizienten mit Elementen eines endlichen Feldes von n+1=$2^n$ Elementen assoziiert sind, worunter $\alpha$ nicht Null ist und ein Nicht-Einheitselement ist, wobei der Decoder folgendes aufweist:

2t Polynomzähler (12-14), die aufeinanderfolgend die M Daten jeder Sequenz empfangen, wobei der Polynomzähler vom Rang i (i=0,1... 2t-1) ist und den Koeffizienten ($S_i$) des Terms des Grades i eines Syndrompolynoms vorsieht, und zwar gleich dem Wert des erwähnten Polynoms des Grades M-1 für die Wurzel $\alpha^{B+i}$, eine Schaltung (20) zum Liefern der Koeffizienten eines Fehlerlokator- oder -lokalisierungspolynoms ($\lambda$) des Grades höchtens gleich t, aus den Koeffizienten des Syndrompolynoms; und eine Schaltung (30) zum Auffinden der Wurzeln des Fehlerlokatorpolynoms durch aufeinanderfolgendes Ausprobieren der M Werte des endlichen Feldes;

dadurch gekennzeichnet, daß:

dem Polynomzähler (12-14) des Rangs i ein Multiplizierer (44) um $\alpha^{(B+i)(N-M)}$ vorhergeht; und
daß die Schaltung (30) zum Auffinden der Wurzeln des Fehlerlokatorpolynoms sukzessive Werte $\alpha^1$ bis $\alpha^M$ ausprobiert.

2. Der Reed-Solomon-Decoder nach Anspruch 1, dadurch gekennzeichnet, daß dann, wenn N=k(N-M), wobei k eine ganze Zahl ist, der Decoder k Multiplizierer (44) mit $\alpha^{B(N-M)}$, $\alpha^{(B+1)(N-M)}$, ...$\alpha^{(B+k-1)(N-M)}$ aufweist, wobei der Multiplizierer des Rangs i (i=0, 1,... k-1) den Polynomzählern der Ränge i+pk vorausgeht, wobei p sich von 0 bis zu dem ganzen Teil von (2t-i-1)/k verändert.

3. Der Reed-Solomon-Decoder nach Anspruch 1, dadurch gekennzeichnet, daß die Schaltung (30) zum Berechnen der Wurzeln des Fehlerlokatorpolynoms ($\lambda$) für jeden Koeffizienten des Terms des Grades i des Fehlerlokatorpolynoms folgendes aufweist:

ein Register (32), das anfänglich den Koeffizienten speichert, und einen Multiplizierer (33) angeschlossen zur aufeinanderfolgenden Ersetzung des Inhalts des Registers mit seinem vorhergehenden Inhalt multipliziert mit $\alpha^i$, wobei die Ausgangsgröße jedes Multiplizierers an einen entsprechenden Eingang eines Addierers (34) angelegt wird.

4. Der Reed-Solomon-Decoder nach einem der Ansprüche 1 bis 3, dadurch gekennzeichnet, daß N=255, M=204, B=0 und t=8.

**Claims**

1.  A Reed-Solomon decoder receiving sequences of M n-bit data corresponding to coefficients of polynomials of degree M-1, these polynomials being multiples of a generator polynomial having successive roots $\alpha^B$ to $\alpha^{B+2t-1}$, where B is a constant, the coefficients being associated with elements of a finite field of $N+1=2^n$ elements among which $\alpha$ is a non-zero and non-unity element, the decoder including:

    -   2t polynomial counters (12-14) successively receiving the M data of each sequence, the polynomial counter of rank i (i=0,1... 2t-1) providing the coefficient ($S_i$) of the term of degree i of a syndrome polynomial, equal to the value of said polynomial of degree M-1 for the root $\alpha^{B+i}$,
    -   a circuit (20) for providing the coefficients of an error locator polynomial ($\lambda$) of degree at most equal to t, from the coefficients of the syndrome polynomial; and
    -   a circuit (30) for finding the roots of the error locator polynomial by successively trying M values of the finite field;

    characterized in that:

    -   said polynomial counter (12-14) of rank i being preceded by a multiplier (44) by $\alpha^{(B+i)(N-M)}$; and
    -   said circuit (30) for finding the roots of the error locator polynimal successively tries values $\alpha^1$ to $\alpha^M$.

2.  The Reed-Solomon decoder of claim 1, characterized in that, if N=k(N-M), where k is an integer, the decoder includes k multipliers (44) by $\alpha^{B(N-M)}$, $\alpha^{(B+1)(N-M)}$, ... $\alpha^{(B+k-1)(N-M)}$, respectively, the multiplier of rank i (i=0, 1,... k-1) preceding the polynomial counters of ranks i+pk, where p varies from 0 to the integer part of (2t-i-1)/k.

3.  The Reed-Solomon decoder of claim 1, characterized in that said circuit (30) for calculating the roots of the error locator polynomial ($\lambda$) includes, for each coefficient of term of degree i of the error locator polynomial, a register (32) initially storing said coefficient, and a multiplier (33) connected to successively replace the content of the register with its preceding content multiplied by $\alpha^i$, the output of each multiplier being provided to a respective input of an adder (34).

4.  The Reed-Solomon decoder of any of claims 1 to 3, characterized in that N=255, M=204, B=0, and t=8.

Fig 1

Fig 2

Fig 3

Fig 4

Fig 5

Fig 6